# FASCICULE DE BREVET EUROPEEN

(11) **EP 3 151 296 B1**
(45) Date de publication et mention de la délivrance du brevet: **02.10.2019**
(21) Numéro de dépôt: 16191723.2
(22) Date de dépôt: 30.09.2016
(51) Int. Cl.: H01L 45/00

(54) **PROCÉDÉ DE RÉALISATION D'UNE CELLULE MÉMOIRE RÉSISTIVE**
VERFAHREN ZUR HERSTELLUNG EINER RESISTIVEN SPEICHERZELLE
METHOD FOR MANUFACTURING A RESISTIVE MEMORY CELL

(30) Priorité: 30.09.2015 FR 1559316
(43) Date de publication de la demande: 05.04.2017
(73) Titulaire: COMMISSARIAT À L'ÉNERGIE ATOMIQUE ET AUX ÉNERGIES ALTERNATIVES, 75015 Paris (FR)
(72) Inventeur: BERNASCONI, Sophie, 38190 LAVAL (FR); CHARPIN-NICOLLE, Christelle, 38120 FONTANIL-CORNILLON (FR); DE LUCA, Anthony, 38640 CLAIX (FR)
(74) Mandataire: Hautier, Nicolas

(56) Documents cités:
- EP-A2- 0 269 225
- US-A1- 2013 001 501

## Description

### DOMAINE DE L'INVENTION

La présente invention concerne, en général, une cellule mémoire résistive, et plus particulièrement, une cellule mémoire résistive non volatile et son procédé de réalisation.

### ARRIERE-PLAN TECHNOLOGIQUE

Les mémoires résistives de type OxRRAM (acronyme en anglais pour « Oxide-Based Resistive Random Access Memories ») comprenant typiquement une couche d'oxyde métallique, sont préférentiellement choisies pour les applications non-volatiles, dans le but de remplacer les mémoires de type Flash. Elles présentent notamment pour avantage d'être compatibles avec le procédé de fin de ligne (acronyme BEOL en anglais pour « Back-End Of Line ») de la technologie CMOS (acronyme en anglais pour « Complementary Metal-Oxide-Semiconductor »).

Les mémoires résistives OxRRAM sont des dispositifs comprenant notamment une couche d'oxyde métallique disposée entre deux électrodes. La résistance électrique de tels dispositifs peut être modifiée par des opérations d'écriture et d'effacement. Ces opérations d'écriture et d'effacement permettent de faire passer le dispositif à mémoire résistive OxRAM d'un état basse résistance LRS (acronyme en anglais pour « Low Resistive State ») à un état haute résistance HRS (acronyme en anglais pour « High Resistive State »), et inversement.

Lors d'étapes de programmation, c'est-à-dire lorsqu'une tension et un courant suffisants sont appliqués au dispositif, avec une limitation en courant traversant le dispositif, inférieure, par exemple, à quelques milliampères (mA), des filaments conducteurs peuvent sélectivement être crées (état LRS) et être rompus (état HRS) entre les électrodes au travers de la couche d'oxyde.

De cycle en cycle, les résistances des états basse résistance LRS et haute résistance HRS ont tendance à évoluer. Une variabilité de ces résistances LRS et HRS est donc observée au cours de la vie de ces cellules mémoires.

Cette variabilité est également observée de cellule à cellule.

Cette variabilité est particulièrement importante pour l'état de haute résistance HRS, induisant une diminution de la fenêtre de programmation, voire une perte totale de la fenêtre de programmation. Ce problème de variabilité est aujourd'hui un réel frein à l'industrialisation.

Ce souci demeure malgré de nombreux efforts réalisés dans le domaine des procédés de réalisation des mémoires résistives et de méthodes de programmation.

Par ailleurs, de nombreuses études ont été réalisées afin de réduire la variabilité des performances électriques par la réduction de la surface de contact entre l'une des électrodes et la couche d'oxyde.

En particulier, il a été montré dans la publication : « Conductive Filament Control in Highly Scalable Unipolar Resistive Switching Devices for Low-Power and High-density Next Génération Memory », Kyung-Chang Ryoo et al., IEDM2013, qu'une solution pour réduire les dimensions du dispositif est de réduire la surface de contact entre l'une des électrodes et la couche d'oxyde. Cette solution implique des procédés de mise en oeuvre complexes et couteux.

Le document US8470681 propose d'ajouter un élément de perturbation dans la couche d'oxyde et sur l'électrode inférieure, de sorte à favoriser la formation d'un filament conducteur au niveau de la zone où se situe ledit élément de perturbation. L'ajout de cet élément génère un champ de contraintes plus important dans le dispositif. Dans ce même document, un autre mode de réalisation consiste à réaliser une forme en cône ou en pyramide dans l'électrode inférieure, avant de procéder au dépôt de la couche d'oxyde.

Le document EP 0 269 225 A2 concerne une structure comportant de multiples zones mémoires définies par l'interconnexion de deux ensembles de lignes conductrices parallèles, les deux ensembles étant perpendiculaires l'un à l'autre.

Ces solutions ont pour inconvénients de rajouter de nombreuses étapes de réalisation du dispositif. Par ailleurs ces étapes sont complexes et il est peu aisé d'atteindre une bonne reproductibilité.

Par ailleurs, la réduction de la surface de l'électrode supérieure rend complexe la reprise de contact au niveau de cette électrode.

Le document FR2998708 propose de minimiser les dimensions du point mémoire formé par le matériau à l'intérieur duquel se créer le filament conducteur entre les deux électrodes de la cellule mémoire CBRAM. L'invention concerne essentiellement les « mémoires à conduction ionique (mémoires CBRAM ou « Conductive Bridging RAM », mais peut être étendue à d'autres types de mémoires. Elle requiert plusieurs niveaux de lithographie. Une des séquences technologiques proposées est la suivante : réalisation d'une ligne métallique, réalisation d'une électrode inférieure inerte, par exemple, par un procédé damascène, réalisation d'une électrode de confinement comprenant un matériau soluble, dépôt d'un diélectrique, réalisation d'un via additionnel par lithogravure, réalisation d'espaceurs (dépôt, gravure), remplissage par un matériau, polissage mécano-chimique, puis nouveau dépôt d'une couche diélectrique, réalisation d'un via par lithogravure, réalisation d'espaceurs et remplissage par un matériau. L'objectif est de créer un effet de pointe sur l'électrode supérieure, mais de conserver un volume d'électrolyte suffisant (applications CBRAM). Le document US8377789 vise un même objectif en recherchant un effet de pointe sur l'oxyde métallique de transition.

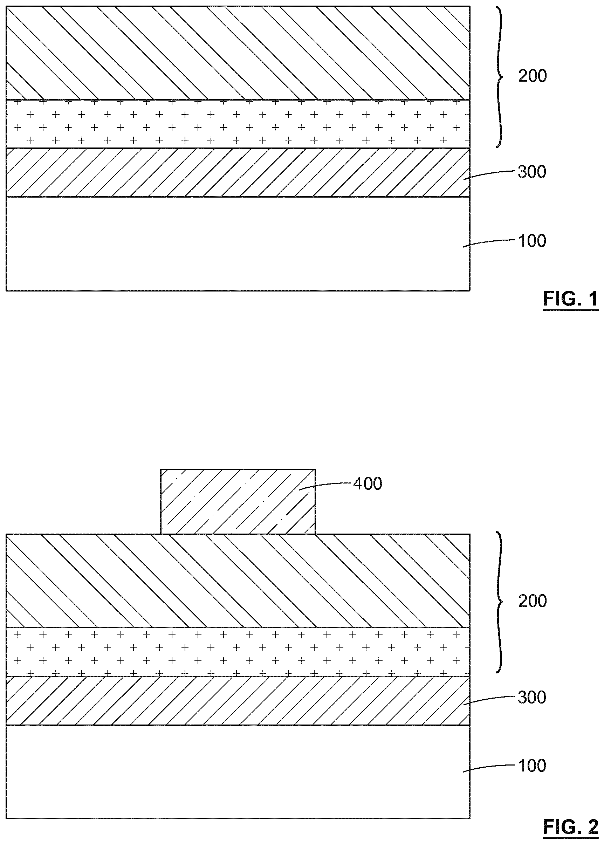

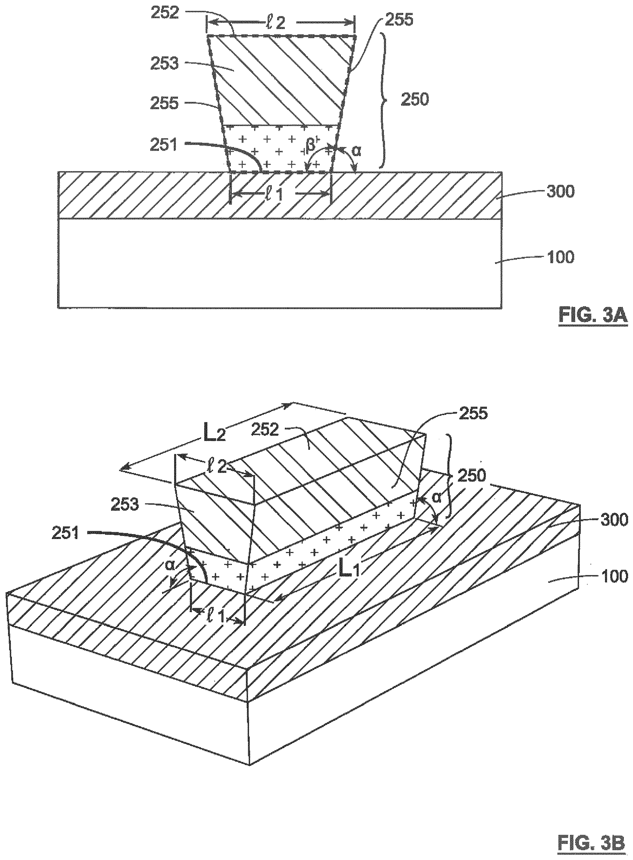

Des inconvénients apparaissent dans ce type de dispositif. Tout d'abord, des problèmes peuvent survenir lors des remplissages de via, en particulier dans une optique de minimisation des dimensions. Par ailleurs, le procédé de réalisation de tels dispositifs est difficile à mette en oeuvre en terme de réalisation technologique et de reproductibilité. Par ailleurs, le document US20130001501 montre une structure de mémoire résistive avec un contour du électrode (208) incliné par rapport à la couche diélectrique (206) dans les figures 2 et 3.

Ainsi dans toutes les solutions connues, afin de former une surface de contact réduite entre l'une au moins des électrodes et la couche d'oxyde, il est nécessaire de recourir à des étapes multiples et donc coûteuses. Notamment, les étapes de lithographie, de dépôts, de planarisation, nécessaires à l'obtention de dimensions nanométriques au niveau du contact entre les électrodes et le matériau diélectrique de la couche d'oxyde sont complexes et requièrent des étapes de développement lourdes et pas toujours parfaitement reproductibles. Par ailleurs, une reprise de contact réalisée sur une petite surface entraîne inévitablement des contraintes supplémentaires au niveau de l'industrialisation.

La présente invention vise à résoudre tout ou, du moins, une partie des inconvénients des techniques actuelles. Il serait notamment avantageux de proposer une solution pour réduire, voire supprimer, la variabilité des résistances HRS et/ou LRS observées cycle après cycle pour des dispositifs à mémoire résistive, tout en limitant ou évitant les inconvénients des procédés de réalisation connus de l'art antérieur mentionnés ci-dessus.

### RESUME DE L'INVENTION

La présente invention concerne un procédé de réalisation d'une cellule mémoire résistive à partir d'un empilement de couches comprenant au moins une première électrode et une couche diélectrique surmontant la première électrode selon la revendication indépendante 1 et un dispositif d'une cellule mémoire résistive selon la revendication indépendante 12.

Le procédé de la présente invention permet de réaliser une cellule mémoire en utilisant des étapes simples de lithographie et de gravure de la deuxième électrode. Au lieu de minimiser le plus possible les dimensions de la couche diélectrique à l'intérieur de laquelle se forme ou se déforme le filament conducteur pour passer alternativement des états LRS et HRS, l'invention prévoit des étapes conventionnelles de lithographie (avantageusement une lithographie en ultraviolet profond), moins coûteuses pour réduire les dimensions de l'une des deux électrodes. Les contraintes sur les dimensions sont ainsi relâchées. L'étape de gravure permet avantageusement de minimiser la taille de la zone « active » d'une mémoire résistive de type Ox-RAM. Par ailleurs, la surface S2 n'a pas besoin d'être très petite ce qui favorise la reprise de contact au niveau de la deuxième électrode.

La présente invention propose ainsi un procédé simple, fiable et reproductible, permettant de relâcher les contraintes au niveau de la reprise de contact en haut du point mémoire (pas d'étape de lithographie coûteuse), tout en minimisant la zone effective de formation du filament conducteur.

La présente invention concerne également une cellule mémoire comprenant un empilement de couches comprenant une première électrode et une couche diélectrique. Une deuxième électrode, positionnée sur la couche diélectrique, est configurée de sorte à former un élément en saillie au-dessus de la couche diélectrique présentant des flancs inclinés, l'angle α entre les flancs de la deuxième électrode formant un angle aigu avec le plan dans lequel s'étend principalement la couche diélectrique.

De manière particulièrement avantageuse, les flancs de l'élément en saillie formant la deuxième électrode sont courbes ou inclinés. Pour ce faire, on effectue une gravure standard comprenant une sur-gravure de la deuxième électrode de sorte à former un élément en saillie dont le profil est sensiblement concave ou trapézoïdal rentrant. Cette approche formant des flancs inclinés, n'est pas standard. En effet, dans les dispositifs microélectroniques, on cherche généralement à obtenir des profils les plus droits possibles ou avec une pente « sortante » (pour que les dépôts réalisés par la suite soient conformes).

Avantageusement, afin de réduire l'instabilité observée cycle après cycle dans la cellule mémoire, la présente invention permet de réduire la surface de contact entre l'au moins une électrode parmi les première et deuxième électrodes et la couche diélectrique. Plus la surface de contact entre l'une des électrodes et la couche diélectrique est réduite, plus le filament conducteur sera guidé dans sa croissance, et plus les caractéristiques électriques seront reproductibles.
Lorsque la surface de contact entre l'au moins une électrode parmi la première électrode et la deuxième électrode et la couche diélectrique est importante, le nombre de chemins parasites de filaments conducteurs qui peuvent être crées lors d'étapes de programmation est élevé, ce qui peut générer une variabilité importante des performances cycle-à-cycle et/ou cellule à cellule.

La présente invention ne requiert pas un ajustement de l'épaisseur de la couche diélectrique. Avantageusement, la couche diélectrique sera « intègre » et non modifiée par la chimie de gravure utilisée lors d'étapes ultérieures du procédé. Ainsi, la présente invention présente une solution alternative ne nécessitant pas une modification de la fabrication de la cellule mémoire suite à un ajustement de la couche diélectrique.

Le procédé selon la présente invention permet de réduire la surface « active » du point mémoire, avantageusement d'un facteur 1000 (par exemple, de 100 nanomètres à 10 nanomètres de dimensions latérales), tout en permettant de réaliser le point mémoire en utilisant des techniques de lithographie relâchées (par exemple une lithographie classique en ultraviolet profond, en anglais « deep UV »), et en ne posant pas de problème spécifique lors de la reprise de contact sur le via supérieur. De la même façon, des techniques de lithographie optique standard pourront être utilisées, avec des alignements (en anglais « overlay »), sur le point mémoire, non critiques. Le procédé est, par ailleurs, facile à mettre en oeuvre, ne nécessitant pas des niveaux de lithographie coûteux et difficiles.

Un autre objet de la présente invention concerne un dispositif microélectronique comprenant une pluralité de cellules mémoire selon l'invention. Par dispositif microélectronique, on entend tout type de dispositif réalisé avec des moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...)

### BREVE INTRODUCTION DES FIGURES

D'autres caractéristiques, buts et avantages de la présente invention apparaîtront à la lecture de la description détaillée qui suit, en regard des dessins annexés, donnés à titre d'exemples, non limitatifs, et sur lesquels les figures 1 à 5 illustrent chacune une étape d'un exemple de procédé de réalisation de la présente invention:
- La FIGURE 1 illustre une vue en coupe d'une étape de dépôt d'un empilement de couches formant une cellule mémoire, comprenant une couche diélectrique disposée entre deux électrodes.
- La FIGURE 2 illustre une vue en coupe d'une étape de lithographie visant à former un élément en saillie.
- La FIGURE 3 illustre une vue en coupe de l'élément en saillie formant une des électrodes.
- La FIGURE 4 illustre une vue en coupe d'une étape de dépôt d'une couche diélectrique recouvrant l'élément en saillie.
- La FIGURE 5 illustre une vue en coupe d'une étape de formation d'une reprise de contact sur l'électrode formée par l'élément en saillie.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs relatives des différentes couches et substrats peuvent ne pas être représentatives de la réalité.

### DESCRIPTION DETAILLEE

Avant d'entamer une revue détaillée de modes de réalisation de l'invention, sont énoncées ci-après des caractéristiques optionnelles qui peuvent éventuellement être utilisées suivant toute association ou alternativement :
- L'étape de définition du contour est effectuée de manière à ce que le contour soit incliné, et de préférence entièrement incliné, par rapport à une direction perpendiculaire au plan principal dans lequel s'étend la couche diélectrique.
- La deuxième électrode comporte au moins deux flancs adjacents inclinés par rapport à la perpendiculaire à un plan dans lequel s'étend principalement la couche diélectrique.
- La deuxième électrode comporte au moins quatre flancs adjacents inclinés par rapport à la perpendiculaire à un plan dans lequel s'étend principalement la couche diélectrique.
- La deuxième électrode comporte un contour continu circulaire formant un tronc de cône dont la plus petite base est tournée au regard et de préférence au contact de la couche diélectrique.
- La deuxième électrode forme un élément en saillie de base polygonale, par exemple carrée ou rectangulaire. Selon un autre mode de réalisation, la deuxième électrode forme un élément en saillie de circulaire. La forme de cette base est définie par la forme de la face de l'élément en saillie tournée en regard ou au contact de la couche diélectrique.
- La deuxième surface S2 forme une reprise de contact pour la deuxième électrode.
- L'étape de définition du contour de la deuxième électrode est effectuée de manière à ce que l'élément en saillie définisse une première surface S1 en regard de la couche diélectrique et une deuxième surface S2, opposée à la première, la première surface S1 étant inférieure à la deuxième surface S2; lesdites surfaces S1, S2 s'étendant sensiblement parallèlement au plan dans lequel la couche diélectrique s'étend principalement. Ainsi, S1, S2 s'étendent perpendiculairement à l'épaisseur de la couche diélectrique. Cette étape comprend au moins une gravure.
- L'étape de définition comprend une gravure effectuée de manière à définir les flancs inclinés et les surfaces S1 et S2.
- L'étape de définition comprend une gravure selon une dimension en épaisseur de la deuxième électrode. Autrement dit, l'étape de définition comprend une gravure anisotrope.
- La gravure est au moins en partie isotrope.
- La gravure comporte une phase chimique, de préférence choisie parmi une gravure sèche.
- On modifie au moins le temps de gravure pour ajuster l'inclinaison des flancs de la deuxième électrode, formés par la gravure de ladite deuxième électrode.
- De préférence les flancs inclinés de la deuxième électrode forment un angle α aigu avec le plan dans lequel s'étend principalement la couche diélectrique.
- L'étape de définition comprend une gravure effectuée de manière à définir les flancs de la deuxième électrode formant l'angle α avec le plan dans lequel s'étend principalement la couche diélectrique.
- L'angle α est compris entre 10° et 80°.
- L'angle α est constant ou non sur la hauteur des flancs.
- La couche diélectrique est plane.
- Le ratio entre la première surface S1 et la deuxième surface S2 de la deuxième électrode est inférieur à 0,8. Il est de préférence compris entre 0,01 et 0,25 (0,01 correspondant à l1=0,1*l2 soit une réduction de 90% de l2 et 0,25 correspondant à l2=0,5*l1 soit une réduction de l2 de 50%).
- L'élément en saillie présente une largeur l1 au niveau de sa face en contact avec la couche diélectrique et présente une largeur l2 au niveau de sa face opposée à celle en contact avec la couche diélectrique, et dans lequel le l1 est inférieure à l2. Autrement dit, l'élément en saillie comprend une première dimension de largeur l1 de la première surface S1 inférieure à une deuxième dimension de largeur l2 de la deuxième surface S2.
- Avantageusement le ratio l1/l2 entre la première dimension de largeur l1 et la deuxième dimension de largeur l2 est inférieur à 0,9 et est de préférence compris entre 0,1 et 0,5.
- la deuxième électrode forme un élément en saillie de base carrée ou rectangulaire.
- l'étape de définition du contour de la deuxième électrode est effectuée de sorte à ce que le contour comprenne au moins deux flancs adjacents inclinés.
- l'étape de définition du contour de la deuxième électrode est effectuée de sorte à ce que le contour comprenne quatre flancs, de préférence chacun de ces flancs étant inclinés.
- l'étape de définition du contour de la deuxième électrode est effectuée de sorte à ce que le contour forme avec les première S1 et deuxième S2 surfaces un tronc de cône.
- la deuxième surface S2 forme une reprise de contact pour la deuxième électrode.
- l'élément en saillie présente une largeur l1 au niveau de sa première surface S1 en regard de la couche diélectrique (300) et présente une largeur l2 au niveau de sa deuxième surface S2, et dans lequel le l1 est inférieure à l2 et dans lequel le ratio l1/l2 entre la première dimension de largeur l1 et la deuxième dimension de largeur l2 est inférieur à 0,9 et est de préférence compris entre 0,1 et 0,5.
- le contour de l'élément en saillie présente deux flancs adjacents dont les dimensions l1 et L1 au niveau de sa première surface S1 en regard de la couche diélectrique (300) respectent le ratio suivant : 1≤L1/l1≤5, de préférence 1≤L1/l1≤3, de préférence 1≤L1/l1≤2 et de préférence 1≤L1/l1≤1.2.
- Selon un mode de réalisation L1/l1= 1. La première surface est donc carrée. Cela permet de réduire les risques d'affaissement de de l'élément en saillie. Selon un mode de réalisation on a les dimensions suivantes: 100nm≤L2 ≤300nm et 90nm≤L1 ≤290nm.
- Selon un mode de réalisation particulier 100nm≤L2 ≤300nm et 30nm≤l1 ≤60nm. Ainsi l'élément en saillie ne forme pas une ligne. Cela permet de faciliter la réalisation de l'élément en saillie en réduisant les risques de déformation ou d'effondrement de l'élément en saillie.
- l'élément en saillie présente une longueur L1 au niveau de sa face en contact avec la couche diélectrique (300) et présente une longueur L2 au niveau de sa face opposée à celle en contact avec la couche diélectrique (300), et dans lequel le L1 est inférieure à L2.
- la surface S1 présente une forme polygonale, de préférence rectangulaire ou carrée ou présente une forme circulaire.
- L'élément en saillie présente une longueur L1 au niveau de sa face en contact avec la couche diélectrique et présente une longueur L2 au niveau de sa face opposée à celle en contact avec la couche diélectrique, et dans lequel le L1 est inférieure à L2. Autrement dit, l'élément en saillie comprend une première dimension de longueur L1 de la première surface S1 inférieure à une deuxième dimension de longueur L2 de la deuxième surface S2.
- L'élément en saillie présente une longueur L1 au niveau de sa face en contact avec la couche diélectrique et présente une largeur L2 au niveau de sa face opposée à celle en contact avec la couche diélectrique, et dans lequel le L1 est inférieure à L2.
- Avantageusement les ratios mentionnés précédemment concernant l1 et l2 sont égaux aux ratios concernant L1 et L2.
- Avantageusement les ratios mentionnés précédemment concernant l1 et l2 sont égaux aux ratios concernant L1 et L2.
- La deuxième électrode présente une première face en regard de la couche diélectrique et de préférence au contact de la couche diélectrique et une deuxième face opposée à la première face. Un élément conducteur d'électricité tel qu'un élément métallique st disposé sur la deuxième face.
- L'étape de définition du contour de ladite deuxième électrode comprend une gravure au moins partielle dans l'épaisseur de la couche diélectrique. Cette étape de gravure peut contribuer à minimiser un peu plus l1 ; ainsi, sur un empilement Hf0₂/Deuxième électrode (Ti 10 nm + TiN 50 nm), les chimies de gravure utilisées pour graver la couche de Hf0₂ sont non sélectives par rapport au Ti et au TiN. En gravant la couche de Hf0₂ partiellement ou non, la deuxième électrode continuera à être gravée.
- La deuxième électrode forme un élément en saillie de base polygonale.
- La deuxième électrode forme un élément en saillie de base circulaire.
- Le dépôt de la deuxième électrode est effectué en pleine plaque.
- L'étape de définition du contour de la deuxième électrode comprend une lithographie pour définir le motif de la deuxième électrode, de préférence une lithographie en ultraviolet profond.
- Après l'étape de formation de la deuxième électrode, on dépose une couche diélectrique au moins sur les flancs et la deuxième surface de l'élément en saillie formant la deuxième électrode et sur la couche diélectrique, le dépôt de la couche diélectrique étant de préférence un dépôt conforme.
- De manière préférée, la couche diélectrique est une couche d'oxyde. Alternativement elle peut être formée par une autre couche.
- Après la formation de la couche diélectrique, une étape de planarisation de ladite couche diélectrique réalisée par un polissage mécano-chimique. La planarisation est réalisée par un polissage mécano-chimique, la gravure permet d'abaisser la hauteur de la couche 500. Préférentiellement, l'étape de planarisation est suivie par une étape de gravure pour « abaisser » le niveau de l'oxyde. Cependant, il est également possible de n'utiliser qu'une étape de polissage mécano-chimique (ayant dans ce cas, le but premier de planariser la surface mais également d'abaisser la hauteur de diélectrique).
- Préférentiellement, on forme, dans ladite couche diélectrique, un passage pour accéder à la deuxième électrode (via).
- On remplit, au moins en partie, le passage par un matériau conducteur de sorte à former une reprise de contact pour la deuxième électrode. Alternativement, il est également possible d'abaisser le niveau du diélectrique jusque sur le point mémoire, puis de déposer un matériau conducteur, et de le graver pour délimiter la zone de reprise contact.
- Une couche diélectrique est positionnée au moins sur les flancs et la deuxième surface de l'élément en saillie formant la deuxième électrode et sur la couche diélectrique.
- Préférentiellement, dans ladite couche diélectrique est formé un passage pour accéder à la deuxième électrode.
- Le passage est, au moins en partie, rempli d'un matériau conducteur de sorte à former une reprise de contact pour la deuxième électrode.
- Le contour de l'élément en saillie formant la deuxième électrode est trapèze dont le côté en regard de la couche diélectrique est plus petit que le côté opposé à la couche diélectrique. Ce contour forme un trapèze rentrant.
- le contour de l'élément en saillie formant la deuxième électrode forme un profil concave au regard du plan perpendiculaire à un plan dans lequel s'étend la couche diélectrique.
- le contour de l'élément en saillie formant la deuxième électrode présente :
   - deux faces sensiblement parallèles entre elles et parallèles à la couche diélectrique
   - des flancs, de préférence deux paires de flancs, joignant lesdites deux faces sensiblement parallèles, les flancs étant courbés, de préférence vers l'intérieur de la saillie. Ainsi les flancs ne sont pas obligatoirement droits, ils peuvent être courbés. De préférence les valeurs des angles α et β mentionnées ci-dessus se retrouvent pour les deux paires de flancs.

Il est précisé que dans le cadre de la présente invention, le terme « sur » ne signifie pas obligatoirement « au contact de ». Ainsi, par exemple, le dépôt d'une couche sur une autre couche, ne signifie pas obligatoirement que les deux couches sont directement au contact l'une de l'autre mais cela signifie que l'une des couches recouvre au moins partiellement l'autre en étant soit directement à son contact, soit en étant séparée d'elle par un film, encore une autre couche ou un autre élément.

On entend par « contour » la paroi courbe ou inclinée dans cette invention, s'étendant depuis la première surface et jusqu'à la deuxième surface. Si la section du contour prise selon un plan parallèle à la couche diélectrique est polygonale, le contour comprendre plusieurs faces, quatre par exemple s'il s'agit d'un carré ou d'un rectangle. Si la section du contour prise selon un plan parallèle à la couche diélectrique est circulaire et que l'élément en saillie forme donc un tronc de cône, alors le contour est délimité par une face continue, ou une infinité de faces.

L'expression la zone de l'élément A est située « au droit » ou « au regard» de l'élément B signifie que la zone de l'élément A et l'élément B sont superposés, en contact direct ou non, suivant une direction perpendiculaire au plan principal dans lequel s'étend la couche diélectrique.

La cellule mémoire selon la présente invention comporte des éléments de dimensions microniques et/ou nanométriques. La description qui suit a pour but préférentiel de présenter une cellule mémoire et son procédé de réalisation en référence aux figures 1 à 5.

La **figure 1** illustre une cellule mémoire comprenant une couche diélectrique 300 disposée entre une première électrode 100 et une deuxième électrode 200. De manière préférée, la couche diélectrique 300 est une couche d'oxyde. Alternativement elle peut être formée par une autre couche. De manière préférée, la couche diélectrique 300 est plane. A titre préféré, on forme d'abord la première électrode 100, puis on dépose la couche diélectrique 300 sur la première électrode 100, et enfin on forme la deuxième électrode 200 sur la couche diélectrique 300. Selon un mode particulièrement avantageux, au moins une couche mais préférentiellement toutes les couches formant la première électrode 100, la deuxième électrode 200 et la couche diélectrique 300 sont déposées en pleine plaque, autrement dit sur toute la surface. De préférence, les dépôts sont conformes.

Préférentiellement, la première électrode 100 peut être formée en un matériau, par exemple, choisi parmi le Platine (Pt), le nitrure de titane (TiN), ou le nitrure de tantale (TaN). Selon un exemple de réalisation non limitatif de l'invention, la première électrode 100 peut être formée d'un empilement de couches comprenant, par exemple, de manière successive, une couche de titane (Ti) d'une épaisseur de 10 nanomètres (nm), une couche à base d'un alliage de cuivre et d'aluminium (AlCu) d'une épaisseur d'environ 440 nm, d'une couche de titane (Ti) d'une épaisseur de 10 nm et d'une couche de nitrure de titane (TiN) d'une épaisseur de 40 nm.

Préférentiellement, la deuxième électrode 200 peut être formée en un matériau à base de titane (Ti), tantale (Ta), hafnium (Hf), de zirconium (Zr), par exemple. Selon un exemple de réalisation, la deuxième électrode 200 est formée d'un empilement de couches comprenant, par exemple, une couche de titane 201 et une couche de nitrure de titane 202.

La couche diélectrique 300 est, quant à elle, de préférence choisie parmi un oxyde métallique, par exemple à base d'oxyde d'hafnium (HfO₂), d'oxyde de titane (TiO₂), d'oxyde de tantale (Ta₂O₅), d'oxyde de Nickel (NiO), d'oxyde de Zinc (ZnO) ou de bicouches (par exemple de type Al₂O₃/Hf0₂).

La **figure 2** illustre une étape de lithographie de sorte que la deuxième électrode 200 forme un élément en saillie 250 au-dessus de la couche diélectrique 300. L'étape de lithographie est destinée à définir des motifs dans la deuxième électrode 200.
Selon un mode réalisation préféré mais non limitatif de l'invention, le motif sera formé par une technique de photolithographie optique ou extrême de type ultra-violet (UV) ou par nano-impression ou par faisceau d'électrons (« ebeam » en anglais).
Selon un mode de réalisation préféré, on utilise une lithographie de type ultra-violet profond (an anglais « deep UV », acronyme DUV). Cette méthode a l'avantage d'être moins coûteuse, plus industrialisable, plus communément utilisée, et également plus rapide.

La lithographique comprend par exemple trois étapes principales: étalement (ou couchage) d'une couche de résine 400 sur la deuxième électrode 200, exposition du film de résine 400 et développement. La résine 400 peut être de tonalité positive ou négative.

Selon un autre mode de réalisation, on réalise une lithographie, par exemple, par faisceau d'électrons ou lithographie électronique, destinée à définir des motifs dans la deuxième électrode 200 ; lesdits motifs pouvant avoir une surface de l'ordre du micromètre carré, et avantageusement de l'ordre de la centaine de nanomètres carrés. Pour des dimensions supérieures à 100nm, on n'a pas du tout intérêt à utiliser la lithographie par faisceau d'électrons (trop long, trop coûteux, etc.), la lithographie par faisceau d'électrons est utilisée pour repousser les limites de la lithographie optique et de dessiner des motifs avec une résolution pouvant aller jusqu'à des dimensions de l'ordre des déca-nanomètres. Afin de réaliser les motifs de faible dimension surfacique, une couche de résine 400, de préférence «négative», est utilisée lors de la lithographie électronique.

La **figure 3** illustre l'étape de définition du contour de la deuxième électrode 200 de sorte à former un élément en saillie 250.
Après l'étape de lithographie, on réalise une étape de gravure de la deuxième électrode 200 dans son épaisseur, le but étant de révéler un élément en saillie 250 formant la deuxième électrode 200, par transfert du motif formé préalablement dans la couche de résine 400. L'élément en saillie 250 forme ainsi un élément ponctuel à la surface de la couche diélectrique 300.
La couche de résine 400 préalablement formée va permettre de protéger la zone de la deuxième électrode 200 qui n'aura pas à être gravée ou qui devra être gravée dans une moindre mesure (c'est-à-dire le haut du motif).
La gravure de la deuxième électrode 200 est au moins en partie isotrope. La gravure est, par exemple, réalisée par gravure au plasma. Elle se décompose en plusieurs étapes : dans un premier temps, la gravure est « standard » : elle comporte préférentiellement une étape de « breakthrough » en anglais, destinée à graver la couche d'oxyde superficielle formée en surface du matériau 200, puis elle est majoritairement anisotrope (pour pouvoir efficacement transférer le motif de résine dans la couche à graver 200), et enfin en dernier lieu davantage « chimique» pour pouvoir assurer une bonne sélectivité de gravure par rapport à une couche d'arrêt (ici la couche diélectrique 300). Cette dernière étape est classiquement appelée « sur-gravure » ou « over-etch » en anglais. Usuellement, elle est utilisée pour enlever le reliquat de matériau après gravure, mais elle est minimisée pour ne pas obtenir des profils « rentrants ». Dans ce cas, l'étape d' «over-etch » est volontairement prolongée pour attaquer latéralement la couche définissant la deuxième électrode 200. La deuxième électrode 200, par exemple en TiN/Ti, peut être gravée avec une chimie en Cl2/Ar ou bien en Cl2/O2. Le temps d' «over-etch » choisi est compris entre 10% et 90% du temps nécessaire pour la gravure anisotrope (usuellement appelé « main-etch » en anglais).
La couche de résine 400 restante est ensuite retirée.
L'élément en saillie 250 obtenu par gravure de la couche 200 a, de préférence, une forme « trapézoïdale » rentrante ou un profil concave. Sur l'exemple illustré en figure 3B la face de l'élément en saillie 250 qui est en regard de la couche diélectrique présente un contour polygonal, ici rectangulaire. On comprend aisément avec le procédé décrit ci-dessus que dans un autre mode de réalisation le contour est circulaire. L'élément en saillie 250 forme alors un cône ou plutôt un tronc de cône qui se rétrécie en se rapprochant de la couche diélectrique 300. Vu en coupe, ce mode de réalisation correspond à la figure 3A.
La paroi joignant les deux surfaces S1 et S2 est désignée contour. Cette paroi est inclinée par rapport à une perpendiculaire au plan contenant la surface S1. Cette paroi peut être formée d'une pluralité de faces ou d'une seule face continue dans le cas d'un tronc de cône.
L'élément en saillie comprend une première surface S1 251 en regard de ou au contact de la couche diélectrique 300 et une deuxième surface S2 252, opposée à la première S1 251. Avantageusement la première surface S1 251 est inférieure à la deuxième surface S2 252. Les surfaces S1, S2 251, 252 s'étendent perpendiculairement à l'épaisseur de la couche diélectrique 300.

De préférence le ratio S1/S2 entre la première surface S1 251 et la deuxième surface S1 252 de l'élément en saillie 250 de la deuxième électrode 200 est inférieur à 0,8 et est compris entre 0,01 et 0,25.

L'élément en saillie 250, lorsque sa base forme un rectangle comme dans le mode de réalisation non limitatif illustré en figure 3B, comprend une première dimension de largeur l1 de la première surface S1 251 inférieure à une deuxième dimension de largeur l2 de la deuxième surface S2 252. Le ratio entre la première dimension de largeur l1 et la deuxième dimension de largeur l2 est compris entre 0,1 et 0,9, et préférentiellement compris entre 0,1 et 0,5.

De manière particulièrement avantageuse, les flancs 255 de l'élément en saillie 250 de la deuxième électrode 200 sont courbes ou inclinés. L'angle α entre les flancs 255 de la deuxième électrode 200 forme un angle aigu avec le plan dans lequel s'étend la couche diélectrique 300. Le flanc 255 présente une face externe tournée vers l'extérieur de l'élément en saillie 250 et une face interne, cette dernière définissant l'espace occupé par l'élément en saillie 250.

Du fait de l'inclinaison du flanc 255, la face externe du flanc 255 est tournée en regard de la face supérieure de la couche diélectrique 300. L'angle α est formé entre la face externe du flanc et la face supérieure de la couche diélectrique 300. Un angle β est formé entre la face interne du flanc et la face supérieure de la couche diélectrique 300. Les angles α et β forment avantageusement des angles supplémentaires (la somme de leur mesure faisant 180 degrés). L'angle α est, de préférence, compris entre 10° et 80°. L'angle α est constant ou peut au contraire varier sur la hauteur du flanc.

Pour créer un profil concave de l'élément en saillie 250 et notamment favoriser la formation de flancs 255 inclinés, une gravure standard avec une sur-gravure (en anglais « overetch ») spécifique est de préférence requise. Pour ce faire, on effectue une gravure standard comprenant une surgravure de la deuxième électrode de sorte à former un élément en saillie dont le profil est sensiblement concave ou trapézoïdal rentrant. Cette approche formant des flancs inclinés, n'est pas standard.

En effet, dans les procédés connus de réalisation de dispositifs microélectroniques, on cherche généralement à obtenir des profils les plus droits possibles ou avec une pente « sortante » (pour que les dépôts réalisés par la suite soient conformes). Pour obtenir un profil vertical, la sur-gravure est habituellement minimisée et ne sert qu'à enlever le reliquat de matériau après gravure. La sur-gravure est essentiellement chimique et donne des profils fortement isotropes en cas de temps de gravure fortement prolongé.

Dans le cadre de la présente invention, on modifie avantageusement au moins le temps de sur-gravure pour ajuster l'inclinaison des flancs 255 (soit l'angle a) de l'élément en saillie 250, formés par la gravure de la deuxième électrode 200. Plus exactement, on fait varier le ratio entre le temps de gravure de l'over-etch et le temps de la gravure anisotrope (également appelée gravure « main-etch » en anglais). Cela revient à jouer sur le ratio entre le bombardement ionique et la dissociation des ions dans le plasma, ou encore sur le rapport : puissance des bobines/puissance des électrodes.
Le temps d'over-etch choisi est compris entre 10% et 90% du temps nécessaire pour la gravure anisotrope (usuellement appelé « main-etch »). Selon un mode de réalisation, l'étape de définition du contour de ladite deuxième électrode 200 comprend une gravure au moins partielle dans l'épaisseur de la couche diélectrique 300. Cette étape de gravure peut contribuer à minimiser un peu plus l1 ; ainsi, sur un empilement Hf02/Deuxième Electrode (Ti 10 nm + TiN 50 nm), les chimies de gravure utilisées pour graver la couche de Hf02 sont non sélectives par rapport au Ti et au TiN. En gravant la couche de Hf02 partiellement ou non, la deuxième électrode 200 continuera à être gravée.

Avantageusement, l'élément en saillie 250 présente, outre la paire de flancs 255, une autre paire de flancs 253 qui s'étend depuis les faces de l'élément en saillie 250 qui sont parallèles à la couche 300. De manière avantageuse ces flancs 253 présentent la même inclinaison ou la même courbure que les flancs 255. L'inclinaison ou la courbure des flancs 253 est formée au cours des mêmes étapes que l'inclinaison ou la courbure des flancs 255.

Comme illustré en figure 3B, la longueur L1 de la première surface S1 251 l'élément en saillie 250 est inférieure à la longueur L2 de la deuxième surface S2 252. Les ratios concernant les longueurs L1 et L2 sont de préférence égaux aux ratios mentionnés dans la présente description concernant les largeurs l1 et l2.

Si la gravure pour obtenir l'inclinaison du contour de l'élément en saillie est isotrope, la différence de longueur l2-l1 sera égale à la différence de longueur L2-L1. De préférence, la deuxième surface S2 252 est au contact d'un élément métallique pour assurer la reprise de contact électrique avec l'électrode 200.

Comme illustré en figure 3B par exemple, l'élément en saillie 250 ne forme pas une longue ligne mais une électrode ponctuelle.
Ainsi on aura 1≤L1/l1≤5, de préférence 1≤L1/l1≤2, de préférence 1≤L1/l1≤1.5.
Selon un mode de réalisation avantageux de préférence 1≤L1/l1≤1.2 et L1=l1. Cela permet de renforcer la tenue mécanique de l'élément en saillie 250.
Par exemple 100nm≤L1 ≤300nm (10⁻⁹ mètres). Par exemple 30nm≤ l1≤60nm (10⁻⁹ mètres).
Selon un autre mode de réalisation, L2=100nm, l2=50nm, L1=80nm et l1=30nm.
Selon un autre mode de réalisation, L2=100nm, l2=100nm, L1=60nm et l1=60nm.
Avec ces dimensions on augmente fortement la stabilité des états HRS et LRS, on facilite la reprise de contact sur la face supérieure de l'élément en saillie 250 et on facilite le procédé de réalisation du fait que la tenue mécanique de l'élément en saillie est renforcée.

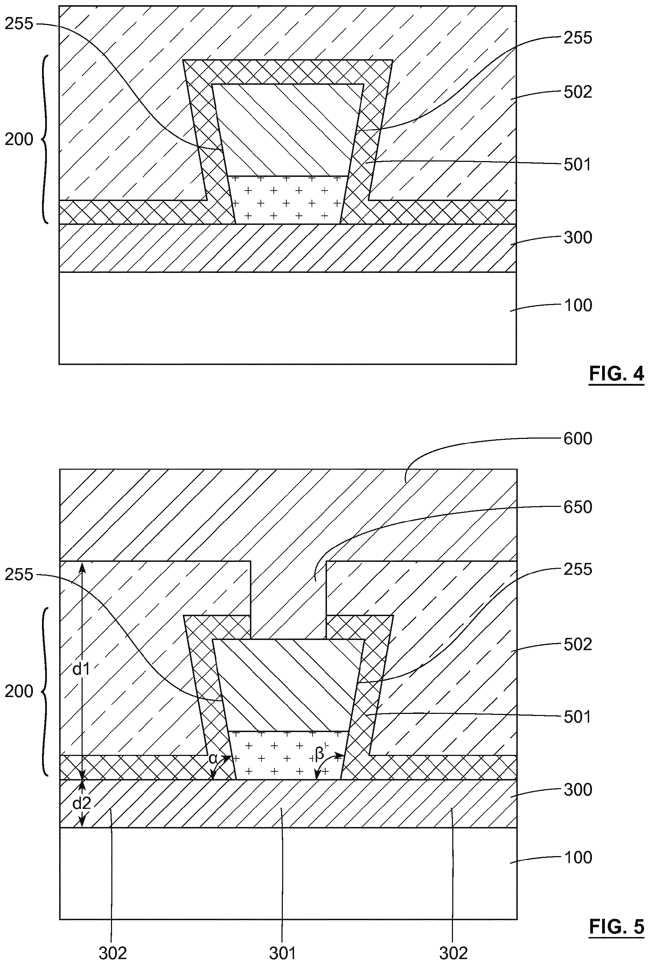

La **figure 4** illustre une étape de formation d'une couche diélectrique 500, après l'étape de formation de l'élément en saillie 250 formant la deuxième électrode 200. La couche diélectrique 500 est réalisée de sorte à recouvrir, de préférence, toute la cellule mémoire et au moins l'élément en saillie 250 et la couche diélectrique 300. Préférentiellement, la couche diélectrique 500 comprend un matériau isolant, par exemple choisi parmi l'oxyde de silicium (SiO2), le nitrure de silicium (SiN), le carbure de silicium (SiC). Selon un mode de réalisation la couche diélectrique 500 comprend une seule couche, par exemple à base d'oxyde de silicium. Selon un autre mode de réalisation illustré en figure 4, mais non limitatif de l'invention, la couche diélectrique 500 est formée d'une bi-couche dont une première couche 501, par exemple, de nitrure de silicium d'une épaisseur de 30 nanomètres et une deuxième couche 502, par exemple, d'oxyde de silicium d'une épaisseur de 300 nanomètres. Le dépôt de SiN se fait par exemple en utilisant une technique de dépôt chimique en phase vapeur assisté par plasma (acronyme PECVD en anglais pour « Plasma Enhanced Chimical Vapor Déposition »). De préférence le dépôt de la première couche 501 est un dépôt conforme. La deuxième couche 502 quant à elle, forme une couche d'encapsulation qui encapsule la deuxième électrode 200 et la première couche 501. Cette couche d'encapsulation permet de protéger le flanc du contour, par exemple d'une oxydation. Par ailleurs, cette couche d'encapsulation permet de maintenir mécaniquement l'élément en saillie, surtout lorsque le ratio L1/l1 est grand.

L'épaisseur de la couche diélectrique 500 est comprise entre 50 nm et 500 nm, de préférence de l'ordre de 300 nm. Cette épaisseur dépend de la hauteur maximale de l'élément en saillie 250, autrement dit de l'épaisseur de la deuxième électrode 200, initialement déposée.
Avantageusement, la possibilité d'un dépôt de la couche diélectrique 500 est faisable, même sur des réductions de dimensions importantes (jusqu'à 10 nanomètres au pied de l'élément en saillie 250.

La **figure 5** illustre une étape de réalisation d'une reprise de contact 600 à partir de l'élément en saillie 250 formant la deuxième électrode 200. Pour réaliser une telle reprise de contact 600, optionnellement on effectue une étape de planarisation de la couche diélectrique 500 afin d'aplanir la surface de ladite couche diélectrique 500. Selon un mode de réalisation, la planarisation est réalisée par un polissage mécano-chimique. Cette planarisation initiale peut être poursuivie par un polissage mécano-chimique ou bien, préférentiellement, par une gravure, de préférence mais non limitativement, par voie sèche. De préférence, cet enchaînement d'étapes est réalisé de sorte à laisser une épaisseur pour la couche diélectrique 500 restante supérieure à l'épaisseur de la deuxième électrode 200 initialement déposée (soit la hauteur de l'élément en saillie 250). Cette épaisseur est prise par rapport à la référence de la couche d'oxyde 300.

On forme ensuite un passage 650 (appelé communément via) dans ladite couche diélectrique 500 de sorte à former un accès à l'élément en saillie 250, formant la deuxième électrode 200. Pour ce faire, on réalise une étape de lithographie standard de sorte à former un motif dans la couche diélectrique 500. Il s'ensuit une étape de gravure de ladite couche diélectrique 500 de sorte à former l'accès à la deuxième électrode 200. Avantageusement, la couche diélectrique 300 reste protégée par la couche diélectrique 500 restante et n'est pas modifiée (en termes de composition, d'oxydation potentielle) par des étapes technologiques (gravure, stripping, polissage, etc.) et garde donc son intégrité.

Une fois le passage 650 formé dans la couche diélectrique 500 donnant un accès direct à la deuxième électrode 200, via l'élément en saillie 250, on effectue une étape de remplissage dudit passage 650 par un matériau conducteur de sorte à former une reprise de contact 600 sur le point mémoire. Selon un mode de réalisation, le matériau conducteur formant la reprise de contact 600 pour la deuxième électrode 200 comprend un matériau à base de titane (Ti), tantale (Ta), d'aluminium (Al), de cuivre (Cu), de tungstène (W) par exemple. Ce matériau de remplissage peut être constitué d'une couche ou de plusieurs couches.
Alternativement, il est également possible d'abaisser le niveau de la couche diélectrique 500 jusque sur le point mémoire, puis de déposer un matériau conducteur (nature de matériau précédemment précisé) et de le graver pour délimiter la zone de reprise de contact.

Avantageusement, pour ce type de cellule mémoire, la reprise de contact 600 sur la deuxième électrode 200 et également sur la première électrode est facilitée puisque les électrodes 100, 200 conservent de larges surfaces.

La cellule mémoire illustrée en figure 5 comprend une première zone 301 où les première et deuxième électrodes 100, 200 sont séparées d'une distance d1, correspondant à l'épaisseur de la couche diélectrique 300 déposée initialement sur la première électrode 100. La cellule mémoire comprend une deuxième zone 302 où les première et deuxième électrodes 100, 200 sont séparées d'une distance d2 correspondant à l'épaisseur de la couche diélectrique 300 déposée initialement sur la première électrode 100 à laquelle s'ajoute l'épaisseur de la couche diélectrique 500, de préférence, isolante électriquement. La distance d1, comme la distance d2 décrite par la suite, sont mesurées selon une direction perpendiculaire au plan principal dans lequel s'étend la couche diélectrique 300. Sur les figures, cette direction est verticale. La distance d1 correspond à la distance la plus courte séparant les première et deuxième électrodes 100, 200 dans la première zone 301. La distance d2 correspond à la distance la plus courte séparant les première et deuxième électrodes 100, 200 dans la deuxième zone 302.

Grâce à cette délimitation d'une première zone 301 et d'une deuxième zone 302 dans la couche diélectrique 300, délimitation avantageusement rendue possible par la formation de l'élément en saillie 250, il est possible de confiner les filaments conducteurs dans une zone spécifique (soit la première zone 301) de ladite couche diélectrique 300 ce qui permet potentiellement de réduire la dispersion des filaments conducteurs. L'invention permet ainsi de réduire la variabilité cycles après cycles des résistances des états LRS et HRS et la variabilité de la fenêtre de programmation, ainsi que la variabilité cellule à cellule. Les performances de la cellule mémoire sont moins dégradées au cours du temps.

De la même manière, dans la présente invention, la surface de la deuxième électrode 200 a été réduite de sorte à réduire la surface de contact 251 entre ladite deuxième électrode 200 et la couche diélectrique 300.
Avantageusement, en diminuant la surface de contact entre au moins une électrode 100, 200 et la couche diélectrique 300, le nombre de chemins parasites est moindre. Les filaments conducteurs, possiblement formés, sont confinés suite à la diminution de la surface de contact entre la deuxième électrode 200 et la couche diélectrique 300. La réduction du nombre de chemins parasites peut avantageusement permettre de réduire encore l'instabilité dans le temps des dispositifs à cellules mémoire et ainsi réduire la variabilité des performances de tels dispositifs, et également minimiser la dispersion des performances électriques entre les différentes cellules mémoires, suite au confinement des filaments conducteurs dans une zone restreinte.

Un mode de réalisation spécifique et non limitatif de l'invention va maintenant être décrit.

Selon cet exemple de réalisation donnée à titre indicatif, la couche diélectrique est une couche d'oxyde formée à base d'oxyde d'hafnium (HfO2) d'une épaisseur comprise entre 5 et 10 nm, la deuxième électrode 200 est formée d'une bi-couche comprenant une première couche 201 à base de titane d'une épaisseur de 10 nm et une deuxième couche 202 à base de nitrure de titane d'une épaisseur de 50 nm et la couche diélectrique 500 est formée d'une bi-couche comprenant une première couche 501 à base de nitrure de silicium d'une épaisseur de 30 nm et une deuxième couche 502 à base d'oxyde de silicium d'une épaisseur de 300 nm. Dans ce mode de réalisation, la hauteur du point mémoire, autrement dit la hauteur de l'élément en saillie 250 (ou épaisseur initiale de la deuxième électrode 200), est de l'ordre de 60 nm. Pour cet exemple de dispositif à cellule mémoire, la dimension critique (CD) en haut du point mémoire (soit sur la deuxième surface S2 252 de l'élément en saillie 250) est de l'ordre de 100 nm alors que la dimension critique (CD) en bas du point mémoire (soit sur la première surface S1 251 de l'élément en saillie 250) est comprise entre 10 nm et 100 nm.

La présente invention n'est pas limitée aux modes de réalisation précédemment décrits mais s'étend à tout mode de réalisation entrant dans la portée des revendications.

## Revendications

1. Procédé de réalisation d'une cellule mémoire résistive à partir d'un empilement de couches comprenant au moins une première électrode (100) et une couche diélectrique (300) surmontant la première électrode (100),
**caractérisé en ce qu'**il comprend au moins une étape de formation d'une deuxième électrode (200) comprenant successivement :
- une étape de dépôt de la deuxième électrode (200) sur la couche diélectrique (300), puis
- une étape de définition du contour de la deuxième électrode (200), de sorte à ce que la deuxième électrode (200) forme un élément en saillie (250) au-dessus de la couche diélectrique (300) et présente un contour,
ledit contour formant, en section dans un plan parallèle à un plan dans lequel la couche diélectrique (300) s'étend principalement, une courbe fermée, et
ledit contour étant entièrement incliné par rapport à la perpendiculaire audit plan dans lequel la couche diélectrique (300) s'étend principalement ou courbe, de manière à ce que l'élément en saillie (250) définisse une première surface S1 (251) en regard de la couche diélectrique (300) et une deuxième surface S2 (252), opposée à la première (251), la première surface S1 (251) étant inférieure à la deuxième surface S2 (252) ; lesdites surfaces S1, S2 (251, 252) s'étendant sensiblement parallèlement audit plan dans lequel la couche diélectrique (300) s'étend principalement.

2. Procédé selon la revendication précédente dans lequel, ledit contour est délimité par au moins un flanc (255) et dans lequel l'étape de définition du contour de la deuxième électrode (200) comprend au moins une gravure effectuée de manière à définir l'au moins un flanc (255) de la deuxième électrode (200), la gravure étant effectuée selon une dimension en épaisseur de la deuxième électrode (200).

3. Procédé selon l'une quelconque des revendications précédentes dans lequel le ratio S1/S2 entre la première surface S1 (251) et la deuxième surface S1 (252) de la deuxième électrode (200) est inférieur à 0,8 et est de préférence compris entre 0,01 et 0,25.

4. Procédé selon l'une quelconque des revendications précédentes dans lequel ledit contour est délimité par au moins un flanc (255) et dans lequel l'étape de définition du contour de la deuxième électrode (200) est effectuée de manière à ce que l'au moins un flanc forment un angle α aigu avec le plan dans lequel s'étend principalement la couche diélectrique (300) et dans lequel l'angle α aigu est compris entre 10° et 80°.

5. Procédé selon l'une quelconque des revendications précédentes dans lequel l'étape de définition du contour de la deuxième électrode (200) est effectuée de sorte à ce que le contour comprenne quatre flancs, chacun de ces flancs étant inclinés.

6. Procédé selon l'une quelconque des revendications précédentes dans lequel l'élément en saillie (250) présente une largeur l1 au niveau de sa première surface S1 (251) en regard de la couche diélectrique (300) et présente une largeur l2 au niveau de sa deuxième surface S2 (252), dans lequel le l1 est inférieure à l2 et dans lequel le ratio l1/l2 entre la première dimension de largeur l1 et la deuxième dimension de largeur l2 est inférieur à 0,9 et est de préférence compris entre 0,1 et 0,5.

7. Procédé selon l'une quelconque des revendications précédentes dans lequel le contour de l'élément en saillie (250) présente deux flancs adjacents dont les dimensions l1 et L1 au niveau de sa première surface S1 (251) en regard de la couche diélectrique (300) respectent le ratio suivant : 1≤L1/l1≤5, de préférence 1≤L1/l1≤3, de préférence 1≤L1/l1≤2 et de préférence 1≤L1/l1≤1.2.

8. Procédé selon l'une quelconque des revendications 1 à 4 dans lequel l'étape de définition du contour de la deuxième électrode (200) est effectuée de sorte à ce que le contour forme avec les première S1 (251) et deuxième S2 (252) surfaces un tronc de cône.

9. Procédé selon l'une quelconque des revendications précédentes dans lequel ladite étape de dépôt de la deuxième électrode (200) est effectuée en pleine plaque.

10. Procédé selon l'une quelconque des revendications précédentes dans lequel l'étape de définition du contour de la deuxième électrode (200) comprend au moins une lithographie pour définir le motif de la deuxième électrode (200), de préférence une lithographie en ultraviolet profond.

11. Procédé selon l'une quelconque des revendications précédentes dans lequel l'au moins une première électrode (100) est plane et la couche diélectrique (300) est plane.

12. Cellule mémoire résistive comprenant un empilement de couches comprenant une première électrode (100), une deuxième électrode (200) et une couche diélectrique (300) positionnée entre la première électrode (100), la deuxième électrode (200), **caractérisé en ce que** la deuxième électrode (200) forme un élément en saillie (250) au-dessus de la couche diélectrique (300) présentant un contour,
ledit contour formant, en section dans un plan parallèle à un plan dans lequel la couche diélectrique (300) s'étend principalement, une courbe fermée, et **caractérisé en ce que**
ledit contour étant entièrement incliné par rapport à la perpendiculaire audit plan dans lequel la couche diélectrique (300) s'étend principalement ou courbe, de manière à ce que l'élément en saillie (250) définisse une première surface S1 (251) en regard de la couche diélectrique (300) et une deuxième surface S2 (252), opposée à la première (251), la première surface S1 (251) étant inférieure à la deuxième surface S2 (252) ; lesdites surfaces S1, S2 (251, 252) s'étendant sensiblement parallèlement audit plan dans lequel la couche diélectrique (300) s'étend principalement.

13. Cellule mémoire résistive selon la revendication précédente dans laquelle le ratio S1/S2 entre la première surface S1 (251) et la deuxième surface S1 (252) de la deuxième électrode (200) est inférieur à 0,8 et est de préférence compris entre 0,01 et 0,25.

14. Cellule mémoire résistive selon l'une quelconque des deux revendications dans laquelle le contour de l'élément en saillie formant la deuxième électrode forme un profil concave au regard du plan perpendiculaire à un plan dans lequel s'étend la couche diélectrique (300).

15. Dispositif microélectronique comprenant une pluralité de cellules mémoire résistives selon l'une quelconque des revendications 12 à 14.

## Patentansprüche

1. Verfahren zum Ausführen einer resistiven Speicherzelle auf Grundlage eines Schichtenstapels, der mindestens eine erste Elektrode (100) und eine dielektrische Schicht (300) umfasst, die die erste Elektrode (100) überdeckt,
**dadurch gekennzeichnet, dass** es mindestens einen Schritt des Bildens einer zweiten Elektrode (200) umfasst, der nacheinander umfasst:
- einen Schritt des Abscheidens der zweiten Elektrode (200) auf der dielektrischen Schicht (300), und anschließend
- einen Schritt des Definierens der Kontur der zweiten Elektrode (200) derart, dass die zweite Elektrode (200) ein vorspringendes Element (250) über der dielektrischen Schicht (300) bildet und eine Kontur aufweist,
wobei die Kontur im Querschnitt in einer Ebene parallel zu einer Ebene, in der sich die dielektrische Schicht (300) hauptsächlich erstreckt, eine geschlossene Kurve bildet, und
wobei die Kontur in Bezug auf die Senkrechte zu der Ebene, in der sich die dielektrische Schicht (300) hauptsächlich erstreckt oder krümmt, vollständig geneigt ist, sodass das vorspringende Element (250) eine erste Fläche S1 (251) definiert, die der dielektrischen Schicht (300) zugewandt ist, und eine zweite Fläche S2 (252), die der ersten (251) gegenüberliegt, wobei die erste Fläche S1 (251) kleiner ist als die zweite Fläche S2 (252); wobei sich die Flächen S1, S2 (251, 252) im Wesentlichen parallel zu der Ebene erstrecken, in der sich die dielektrische Schicht (300) hauptsächlich erstreckt.

2. Verfahren nach dem vorstehenden Anspruch, wobei die Kontur von mindestens einer Flanke (255) begrenzt wird, und wobei der Schritt des Definierens der Kontur der zweiten Elektrode (200) mindestens ein Ätzen umfasst, das vorgenommen wird, um die mindestens eine Flanke (255) der zweiten Elektrode (200) zu definieren, wobei das Ätzen entlang einer Dickenabmessung der zweiten Elektrode (200) vorgenommen wird.

3. Verfahren nach einem der vorstehenden Ansprüche, wobei das Verhältnis S1/S2 zwischen der ersten Fläche S1 (251) und der zweiten Fläche S1 (252) der zweiten Elektrode (200) kleiner ist als 0,8 und vorzugsweise im Bereich zwischen 0,01 und 0,25 liegt.

4. Verfahren nach einem der vorstehenden Ansprüche, wobei die Kontur von mindestens einer Flanke (255) begrenzt wird, und wobei der Schritt des Definierens der Kontur der zweiten Elektrode (200) so vorgenommen wird, dass die mindestens eine Flanke einen spitzen Winkel *α* zu der Ebene bilden, in der sich die dielektrische Schicht (300) hauptsächlich erstreckt, und wobei der spitze Winkel *α* im Bereich zwischen 10° und 80° liegt.

5. Verfahren nach einem der vorstehenden Ansprüche, wobei der Schritt des Definierens der Kontur der zweiten Elektrode (200) derart vorgenommen wird, dass die Kontur vier Flanken umfasst, wobei jede dieser Flanken geneigt ist.

6. Verfahren nach einem der vorstehenden Ansprüche, wobei das vorspringende Element (250) im Bereich seiner ersten Fläche S1 (251), die der dielektrischen Schicht (300) zugewandt ist, eine Breite l1 aufweist, und im Bereich seiner zweiten Fläche S2 (252) eine Breite l2 aufweist, wobei die l1 kleiner ist als l2, und wobei das Verhältnis l1/l2 zwischen der ersten Breitenabmessung l1 und der zweiten Breitenabmessung l2 kleiner ist als 0,9, und vorzugsweise im Bereich zwischen 0,1 und 0,5 liegt.

7. Verfahren nach einem der vorstehenden Ansprüche, wobei die Kontur des vorspringenden Elements (250) zwei aneinandergrenzende Flanken aufweist, von denen die Abmessungen l1 und L1 im Bereich ihrer ersten Fläche S1 (251), die der dielektrischen Schicht (300) zugewandt ist, das folgende Verhältnis erfüllen: 1≤L1/l1≤5, vorzugsweise 1≤L1/l1≤3, vorzugsweise 1≤L1/l1≤2, und vorzugsweise 1≤L1/l1≤1,2.

8. Verfahren nach einem der Ansprüche 1 bis 4, wobei der Schritt des Definierens der Kontur der zweiten Elektrode (200) derart vorgenommen wird, dass die Kontur mit der ersten S1 (251) und zweiten Fläche S2 (252) einen Kegelstumpf bildet.

9. Verfahren nach einem der vorstehenden Ansprüche, wobei der Schritt des Abscheidens der zweiten Elektrode (200) auf ganzer Platte vorgenommen wird.

10. Verfahren nach einem der vorstehenden Ansprüche, wobei der Schritt des Definierens der Kontur der zweiten Elektrode (200) mindestens eine Lithographie, vorzugsweise eine Lithographie im tiefen Ultraviolett umfasst, um das Muster der zweiten Elektrode (200) zu definieren.

11. Verfahren nach einem der vorstehenden Ansprüche, wobei die mindestens eine erste Elektrode (100) eben ist, und die dielektrische Schicht (300) eben ist.

12. Resistive Speicherzelle, die einen Schichtenstapel umfasst, der eine erste Elektrode (100), eine zweite Elektrode (200) und eine dielektrische Schicht (300) umfasst, die zwischen der ersten Elektrode (100), der zweiten Elektrode (200) positioniert ist, **dadurch gekennzeichnet, dass** die zweite Elektrode (200) ein vorspringendes Element (250) über der dielektrischen Schicht (300) bildet, das eine Kontur aufweist,
wobei die Kontur im Querschnitt in einer Ebene parallel zu einer Ebene, in der sich die dielektrische Schicht (300) hauptsächlich erstreckt, eine geschlossene Kurve bildet, und **dadurch gekennzeichnet, dass**
wobei die Kontur in Bezug auf die Senkrechte zu der Ebene, in der sich die dielektrische Schicht (300) hauptsächlich erstreckt oder krümmt, vollständig geneigt ist, sodass das vorspringende Element (250) eine erste Fläche S1 (251) definiert, die der dielektrischen Schicht (300) zugewandt ist, und eine zweite Fläche S2 (252), die der ersten (251) gegenüberliegt, wobei die erste Fläche S1 (251) kleiner ist als die zweite Fläche S2 (252); wobei sich die Flächen S1, S2 (251, 252) im Wesentlichen parallel zu der Ebene erstrecken, in der sich die dielektrische Schicht (300) hauptsächlich erstreckt.

13. Resistive Speicherzelle nach dem vorstehenden Anspruch, wobei das Verhältnis S1/S2 zwischen der ersten Fläche S1 (251) und der zweiten Fläche S1 (252) der zweiten Elektrode (200) kleiner ist als 0,8 und vorzugsweise im Bereich zwischen 0,01 und 0,25 liegt.

14. Resistive Speicherzelle nach einem der zwei Ansprüche, wobei die Kontur des vorspringenden Elements, das die zweite Elektrode bildet, ein konkaves Profil bildet, das der Ebene senkrecht zu einer Ebene, in der sich die dielektrische Schicht (300) erstreckt, zugewandt ist.

15. Mikroelektronische Vorrichtung, die eine Vielzahl von resistiven Speicherzellen nach einem der Ansprüche 12 bis 14 umfasst.

## Claims

1. Method for producing a resistive memory cell from a stack of layers comprising at least one first electrode (100) and a dielectric layer (300) surmounting the first electrode (100), **characterised in that** it comprises at least one step of forming a second electrode (200) successively comprising:
- a step of depositing the second electrode (200) on the dielectric layer (300), then
- a step of defining the edge of the second electrode (200), such that the second electrode (200) forms a protruding element (250) above the dielectric layer (300) and has an edge,
said edge forming, in the cross-section in a plane parallel to a plane wherein the dielectric layer (300) mainly extends, a closed curve, and
said edge being fully inclined with respect to the perpendicular to said plane wherein the dielectric layer (300) mainly extends or curves, such that the protruding element (250) defines a first surface S1 (251) facing the dielectric layer (300) and a second surface S2 (252), opposite the first (251), the first surface S1 (251) being lower than the second surface S2 (252); said surfaces S1, S2 (251, 252) extending substantially parallel to said plane wherein the dielectric layer (300) mainly extends.

2. Method according to the preceding claim, wherein said edge is delimited by at least one edge (255) and wherein the step of defining the edge of the second electrode (200) comprises at least one etching carried out so as to define the at least one edge (255) of the second electrode (200), the etching being carried out according to a thickness dimension of the second electrode (200).

3. Method according to any one of the preceding claims, wherein the S1/S2 ratio between the first surface S1 (251) and the second surface S1 (252) of the second electrode (200) is less than 0.8 and is preferably of between 0.01 and 0.25.

4. Method according to any one of the preceding claims, wherein said edge is delimited by at least one edge (255) and wherein the step of defining the edge of the second electrode (200) is carried out such that the at least one edge forms an acute angle α with the plane wherein the dielectric layer (300) mainly extends and wherein the acute angle α is of between 10° and 80°.

5. Method according to any one of the preceding claims, wherein the step of defining the edge of the second electrode (200) is carried out such that the edge comprises four edges, each of these edges being inclined.

6. Method according to any one of the preceding claims, wherein the protruding element (250) has a width l1 at the level of the first surface S1 (251) thereof facing the dielectric layer (300) and has a width l2 at the level of the second surface S2 (252) thereof, wherein the l1 is less than l2 and wherein the l1/l2 ratio between the first dimension of width l1 and the second dimension of width l2 is less than 0.9 and is preferably of between 0.1 and 0.5.

7. Method according to any one of the preceding claims, wherein the edge of the protruding element (250) has two adjacent edges of which the dimensions l1 and L1 at the level of the first surface S1 (251) thereof facing the dielectric layer (300) respect the following ratio: 1≤L1/l1≤5, preferably 1≤L1/l1≤3, preferably 1≤L1/l1≤2 and preferably 1≤L1/l1≤1.2.

8. Method according to any one of claims 1 to 4, wherein the step of defining the edge of the second electrode (200) is carried out such that the edge forms, with the first S1 (251) and second S2 (252) surfaces, a cone frustum.

9. Method according to any one of the preceding claims, wherein said step of depositing the second electrode (200) is carried out on a solid plate.

10. Method according to any one of the preceding claims, wherein the step of defining the edge of the second electrode (200) comprises at least one lithography to define the pattern of the second electrode (200), preferably a deep ultraviolet lithography.

11. Method according to any one of the preceding claims, wherein the at least one first electrode (100) is flat and the dielectric layer (300) is flat.

12. Resistive memory cell comprising a stack of layers comprising a first electrode (100), a second electrode (200) and a dielectric layer (300) positioned between the first electrode (100), the second electrode (200), **characterised in that** the second electrode (200) forms a protruding element (250) above the dielectric layer (300) having an edge,
said edge forming, in the cross-section in a plane parallel to a plane wherein the dielectric layer (300) mainly extends, a closed curve, and **characterised in that**
said edge being fully inclined with respect to the perpendicular to said plane wherein the dielectric layer (300) mainly extends or curves, such that the protruding element (250) defines a first surface S1 (251) facing the dielectric layer (300) and a second surface S2 (252), opposite the first (251), the first surface S1 (251) being lower than the second surface S2 (252); said surfaces S1, S2 (251, 252) mainly extending parallel to said plane wherein the dielectric layer (300) mainly extends.

13. Resistive memory cell according to the preceding claim, wherein the S1/S2 ratio between the first surface S1 (251) and the second surface S1 (252) of the second electrode (200) is less than 0.8 and is preferably of between 0.01 and 0.25.

14. Resistive memory cell according to any one of the two claims, wherein the edge of the protruding element forming the second electrode forms a concave profile facing the plane perpendicular to a plane wherein the dielectric layer (300) extends.

15. Microelectronic device comprising a plurality of resistive memory cells according to any one of claims 12 to 14.
